# EUROPEAN PATENT APPLICATION

(11) **EP 4 503 144 A1**
(43) Date of publication of application: **05.02.2025**
(21) Application number: 22936115.9
(22) Date of filing: 07.04.2022
(51) Int. Cl.: H01L 31/052, H01L 31/054

(54) **SOLAR ENERGY UTILIZATION UNIT**

(71) Applicant: Boly Media Communications (Shenzhen) Co., Ltd., Shenzhen, Guangdong 518109 (CN)
(72) Inventor: HU, Xiaoping, Shenzhen, Guangdong 518109 (CN)
(74) Representative: Manitz Finsterwald Patent- und Rechtsanwaltspartnerschaft mbB
(86) International application number: PCT/CN2022/085471
(87) International publication number: WO 2023/193168

(57) **Abstract**

A solar energy utilization unit, comprising a light energy utilization device, a liquid light concentration device and a reflecting structure. The reflecting structure can reflect sunlight to the light energy utilization device located at middle part of the liquid light concentration device. In the liquid light concentration device, a transmission or total reflection phenomenon is formed by sunlight emitted from a transparent liquid to a light-transmitting sidewall or light-transmitting top wall, so that more sunlight converges on a first light energy utilization portion and a second light energy utilization portion of the light energy utilization device. The reflecting structure can reflect some of sunlight, which is outside a receiving range of the liquid light concentration device, to the first light energy utilization portion and the second light energy utilization portion of the light energy utilization device, so as to improve the light concentration efficiency of the solar energy utilization unit.

## Description

### Technical Field

This application relates to structures for the conversion and utilization of light energy, specifically to solar energy utilization units.

### Background of the Invention

Solar energy utilization devices are used for harnessing and utilizing solar energy, for example, by converting solar energy into electricity through photovoltaic panels. With the reduction in costs and increase in efficiency of photovoltaic panels, solar energy utilization devices are finding increasingly more applications. However, the current low-concentration solar energy devices still have room for improvement in terms of their solar concentration efficiency.

### Summary of the Invention

This application primarily provides a novel solar energy utilization unit, showcasing a new structure for the utilization of solar energy.

Based on the aforesaid objectives, a solar energy utilization unit provided in some embodiments of the present application may include:
a light energy utilization device having a first light energy utilization portion and a second light energy utilization portion that are arranged in a back-to-back configuration and are capable of receiving, converting, and utilizing sunlight.
a liquid light-concentration device having an accommodating chamber filled with a transparent liquid, the accommodating chamber having a light-transmissive top wall and an inclined light-transmissive side wall, the light energy utilization device being arranged in the middle of the accommodating chamber, the first light energy utilization portion and the second light energy utilization portion being perpendicular to the light-transmissive top wall, the light-transmissive side wall being arranged on both sides of the light energy utilization device, allowing the sunlight to be transmitted and/or totally reflected from the light-transmissive top wall or the light-transmissive side wall onto the first light energy utilization portion and the second light energy utilization portion; and
a reflecting structure forming a light reflecting chamber with the light-transmissive side wall of the liquid light-concentration device and allowing sunlight entering the light reflecting chamber to be reflected onto the light-transmissive side wall or light-transmissive top wall of the liquid light-concentration device.

In some embodiments, a light inlet in communication with the light reflecting chamber may be provided between the reflecting structure and the liquid light-concentration device for the sunlight to enter.

In some embodiments, the upper end of the light-transmissive side wall may be extended to the reflecting structure and the light reflecting chamber may be sealed, allowing the sunlight to be transmitted from the light-transmissive side wall of the liquid light-concentration device into the light reflecting chamber.

In some embodiments, the light reflecting chamber may be distributed on both sides and the bottom of the liquid light-concentration device.

In some embodiments, the reflecting structure may be a trough-like structure housing the light energy utilization device and the liquid light-concentration device, with an internal reflective surface that directs the sunlight onto the light-transmissive side wall of the liquid light-concentration device.

In some embodiments, the liquid light-concentration device may be an inverted triangular structure in cross section, and the light energy utilization device may be vertically arranged in the middle of the inverted triangular structure.

In some embodiments, the light-transmissive side wall may be a plane, a folded surface, or a curved surface.

In some embodiments, at least a portion of the light-transmissive side wall may be a Fresnel lens tooth surface.

In some embodiments, the Fresnel lens tooth surface may be arranged at the upper end of the light-transmissive side wall.

In some embodiments, the light-transmissive top wall of the liquid light-concentration device may be provided with a light-transmissive cover that, along with the reflecting structure, forms a closed chamber enclosing both the liquid light-concentration device and the light energy utilization device.

In some embodiments, the light-transmissive cover may be a Fresnel lens surface.

In some embodiments, a transparent surface may be overlapped or shared by both the top wall of the liquid light-concentration device and the light-transmissive cover.

In some embodiments, the top wall of the liquid light-concentration device and the light-transmissive cover may allow the sunlight from the light-transmissive side wall or the reflecting structure to be totally reflected, converging part of the sunlight towards the light energy utilization device through total reflection.

In some embodiments, the liquid light-concentration device may comprise two separated closed chambers, with the light energy utilization device arranged between the two closed chambers, and the first light energy utilization portion and the second light energy utilization portion may be each adhered to a vertical light-transmissive wall of one of the two closed chambers, respectively.

In some embodiments, the transparent liquid may comprise deionized pure water, glycerol, alcohol, ethylene glycol, or a mixture thereof.

In some embodiments, the light energy utilization device is a dual-sided photovoltaic panel or a dual-sided photothermal utilization device.

The solar energy utilization unit provided in the present application may be integrated with multiple others to form an array during actual production and installation.

According to the solar energy utilization unit mentioned in above embodiments, which includes a light energy utilization device, a liquid light-concentration device, and a reflecting structure, the reflecting structure can reflect sunlight onto the light energy utilization device arranged in the middle of the liquid light-concentration device; the sunlight in the liquid light-concentration device transmitted from the transparent liquid to the light-transmissive side wall can result in transmission or total reflection phenomena, allowing more sunlight to be converged onto the first and second light energy utilization portions of the light energy utilization device; and the reflecting structure can reflect some sunlight that is outside the receiving range of the liquid light-concentration device onto the first and second light energy utilization portions of the light energy utilization device, thereby enhancing the concentration efficiency of the solar energy utilization unit.

### Brief Description of the Drawings

FIG. 1 is a schematic diagram of a vertical section of a solar energy utilization unit in some embodiments of the present application;
FIG. 2 is a schematic diagram of a vertical section of a solar energy utilization unit in some embodiments of the present application;
FIG. 3 is a schematic diagram of a vertical section of a combined formation formed by solar energy utilization units in some embodiments of the present application; and
FIG. 4 is a schematic diagram of a vertical section of a combined formation formed by solar energy utilization units in some embodiments of the present application.

### Detailed Description

The present disclosure will be further detailed below through specific embodiments with reference to the accompanying drawings. Common or similar elements are referenced with like or identical reference numerals in different embodiments. Many details in the following embodiments are described to facilitate a better understanding of the present application. However, it will be effortlessly recognized by those skilled in the art that some features may be omitted under different circumstances or may be substituted by other components, materials, or methods. For clarity some operations related to the present disclosure are not shown or illustrated herein so as to prevent the core from being overwhelmed by excessive descriptions. For those skilled in the art, such operations are not necessary to be explained in detail, and they can fully understand the related operations according to the description in the specification and the general technical knowledge in the art.

Additionally, the characteristics, operations, or features described in the specification may be combined in any appropriate manner to form various embodiments. At the same time, the steps or actions in the described method can be reordered or adjusted in ways that are obvious to those skilled in the art. Therefore, the various sequences in the specification and drawings are merely for clearly describing a particular embodiment and are not intended to be an order of necessity, unless otherwise stated one of the sequences must be followed.

The serial numbers assigned to components herein, such as "first", "second", etc., are used solely for distinguishing the described objects and do not carry any sequential or technical meaning. The terms "connected", "coupled" and the like here include direct and indirect connections (coupling) unless otherwise specified.

The positional relationships such as up, down, left, and right mentioned herein are all relative and do not have absolute meanings.

The solar energy utilization unit provided in some embodiments of the present application can be designed to receive and harness sunlight for energy conversion, transforming sunlight into electrical energy, thermal energy, and other forms of energy for human use.

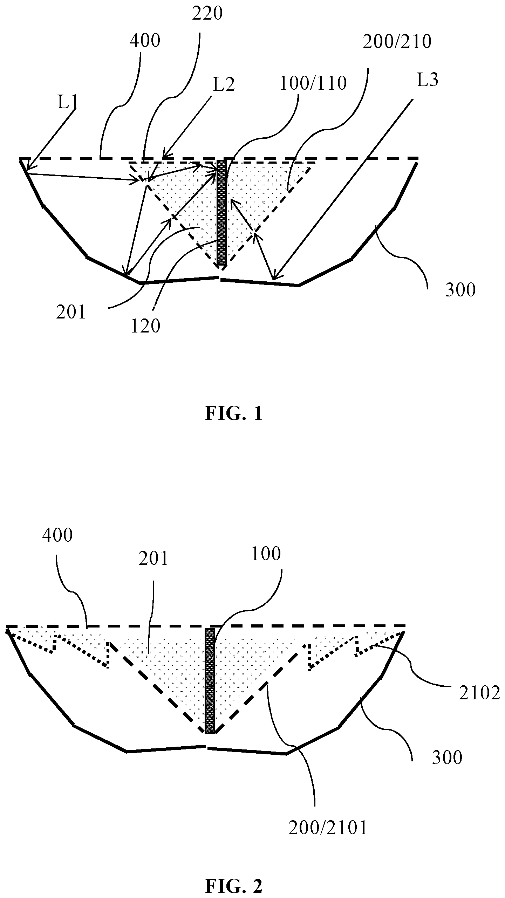

Please refer to FIGS. 1-4. The liquid solar energy utilization unit in the shown embodiment may comprise a light energy utilization device 100, a liquid light-concentration device 200, a reflecting structure 300, and a light-transmissive cover 400.

The light energy utilization device 100 may be provided with a first light energy utilization portion 110 and a second light energy utilization portion 120 that are capable of receiving, converting, and utilizing sunlight and are in a back-to-back configuration. In some embodiments, the light energy utilization device 100 may be one or more of a dual-sided photovoltaic panel, a photothermal utilization device, an integrated photoelectric and thermal energy utilization device, or a concentrated light energy utilization device. The term "photovoltaic panel" broadly refers to any device that directly converts light energy into electrical energy, including various semiconductor photovoltaic panels, photovoltaic films, quantum dot photoelectric conversion devices, etc.. In other embodiments, the first light energy utilization portion 110 and the second light energy utilization portion 120 may be in other forms of solar energy utilization and conversion structures.

A notable feature of the present disclosure is that the light energy utilization device 100 is vertically disposed in the middle of the liquid light-concentration device 200, with the first light energy utilization portion 110 and the second light energy utilization portion 120 being perpendicular to the light-transmissive cover 400.

The liquid light-concentration device 200 may have an accommodating chamber filled with a transparent liquid 201. The cross-section of the liquid light-concentration device 200 (a face parallel to the drawing sheet in FIG. 1) may be of an inverted triangular structure. The accommodating chamber may have two inclined light-transmissive side walls 210 and one horizontal or nearly horizontal light-transmissive top wall 220, allowing sunlight to be transmitted through the light-transmissive side walls 210 or the light-transmissive top wall 220 to the reflecting structure and/or to be totally reflected onto the light energy utilization device 100. The liquid light-concentration device 200 with inclined light-transmissive side walls 210 can adapt to incident light with larger angles of deviation, making it suitable not only for handling the north-south regression deviation of sunlight but also for managing the east-west deviation of sunlight. In some embodiments, the light-transmissive side walls 210 may be planes, folded surfaces, curved surfaces, or combinations thereof. In other embodiments, at least a portion of the light-transmissive side wall 210 may be designed as a Fresnel lens tooth surface, forming a liquid Fresnel lens with the transparent liquid 210; for example, the upper part of the light-transmissive side wall 210 is a Fresnel lens tooth surface while the lower part of the light-transmissive side wall 210 is flat. The liquid light-concentration device 200 may typically include an end (not shown in the figures) that, along with the light-transmissive side wall and the light-transmissive top wall, forms the accommodating chamber.

The light energy utilization device 100 may be arranged within the accommodating chamber, with the first light energy utilization portion 110 and the second light energy utilization portion 120 facing the light-transmissive side wall 210 of the liquid light-concentration device 200, respectively. At least a portion of the sunlight within the accommodating chamber travelling from the transparent liquid 201 towards the light-transmissive side wall 210 exhibits total reflection, converging the sunlight onto the first light energy utilization portion 110 or the second light energy utilization portion 120. The structure of the liquid light-concentration device 200 may be designed such that sunlight from certain angles and traveling from the transparent liquid 201 towards the light-transmissive side walls 210 undergoes total reflection (or total internal reflection), meaning that sunlight from certain angles, instead of being transmitted through the light-transmissive side walls 210, propagates within the liquid light-concentration device 200 under total reflection, converging ultimately onto the first or second light energy utilization portion. For specific designs, sunlight from other angles and traveling from the transparent liquid 201 towards the light-transmissive side walls 210 may be transmitted to the reflecting structure, where it is then concentrated onto the first or second light energy utilization portion of the light energy utilization device.

In these embodiments, the transparent liquid 201 is utilized as a light propagation medium, and the light-transmissive side walls 210 serve both as light-transmitting surfaces and as surfaces for total reflection. Compared to existing technologies, under the same conditions, the liquid light-concentration device 200 can collect more sunlight onto the first or second light energy utilization portion, increasing its concentration ratio.

Meanwhile, to gather more sunlight directed towards the liquid light-concentration device 200, the reflecting structure 300 is arranged on the outer side and bottom of the liquid light-concentration device 200, for instance, on one or more sides of the liquid light-concentration device 200. The reflecting structure 300 may have a reflective surface that can guide sunlight towards the center of the liquid light-concentration device 200. The upper end of the reflecting structure 300 is wider than that of the liquid light-concentration device 200, leaving a light inlet of the reflecting structure between the reflecting structure 300 and the liquid light-concentration device 200 to allow sunlight to enter; and a light reflecting chamber with a light inlet is formed between the reflecting structure 300 and the light-transmissive side wall 210 of the liquid light-concentration device 200. This reflecting structure 300 can expand the range of sunlight received by the liquid light-concentration device 200, enabling it to collect more sunlight that illuminates the light reflecting chamber which then reflects the light back onto the liquid light-concentration device 200, for example, onto the light-transmissive side wall 210 of the liquid light-concentration device 200 via the reflecting structure 300, ultimately guiding it to the first light energy utilization portion 110 or the second light energy utilization portion 120.

In some embodiments, no light inlet is provided between the upper end of the reflecting structure 300 and the liquid light-concentration device 200. Instead, the upper end of the light-transmissive side wall 210 of the liquid light-concentration device 200 may extend to connect with the upper end of the reflecting structure 300, forming a sealed light reflecting chamber between the reflecting structure 300 and the light-transmissive side wall 210 of the liquid light-concentration device 200. sunlight may be transmitted through the light-transmissive side walls 210 into the light reflecting chamber, which then reflects the sunlight entering the light reflecting chamber back onto the light-transmissive side walls 210 of the liquid light-concentration device 200, ultimately guiding it to the first light energy utilization portion 110 or the second light energy utilization portion 120. Similarly, this sealed light reflecting chamber can increase the range of the liquid light-concentration device 200 receiving the sunlight, enabling it to collect more sunlight that illuminates the first light energy utilization portion 110 or the second light energy utilization portion 120.

Specifically, in some embodiments, the light energy utilization device 100 may be directly immersed in a transparent liquid 201, allowing the first light energy utilization portion 110 and the second light energy utilization portion 120 to directly receive sunlight transmitted through the transparent liquid 201.

The liquid light-concentration device 200 may be filled with the transparent liquid 201 partially or fully in its internal space. Preferably, in some embodiments, the transparent liquid 201 may fill the entire accommodating chamber substantially to achieve better results.

In some embodiments, the transparent liquid 201 may be deionized pure water, glycerol, alcohol, ethylene glycol, or a mixture thereof.

Furthermore, the transparent liquid 201 can form a heat transfer structure either directly or indirectly with the first light energy utilization portion 110 and the second light energy utilization portion 120, thereby serving to cool down or absorb heat from the first light energy utilization portion 110 and the second light energy utilization portion 120, enhancing the conversion efficiency of solar energy.

In some embodiments, as shown in FIGS. 1 to 4, the vertical cross section of the liquid light-concentration device 200 may be designed as an inverted triangular structure (V-shape or wedge-shape) with its upper opening being wider than its bottom. The light energy utilization device 100 is vertically disposed in the middle of the inverted triangular liquid light-concentration device 200 to achieve a light concentrating effect. Of course, this shape is just an example, and other shapes may also be adopted.

To prevent dust accumulation and facilitate cleaning, please refer to FIGS. 1 to 4, in some embodiments, a light-transmissive cover 400 is also included, which seals the reflecting structure 300, forming a closed structure. The light-transmissive cover 400 may be a Fresnel lens surface or other light-transmissive structure. The light-transmissive cover 400 may be connected to the reflecting structure 300 as an integral structure through connection methods such as clamping, screwing, adhesion, etc.

In some embodiments, as shown in FIG. 2, to enhance the concentration ratio, any light-transmissive side wall 210 of the liquid light-concentration device includes a first portion 2101 and a second portion 2102. The first portion 2101 may either be flat or curved, while the second portion 2102 may feature a Fresnel lens tooth surface. These two portions have different slopes relative to the light energy utilization device 100; for instance, the slope of the first portion 2101 is smaller, whereas the second portion 2102 is more inclined with a larger slope. The first portion 2101 with a smaller slope is more conducive to converging light onto the first light energy utilization portion 110 and the second light energy utilization portion 120. Of course, the first and second portions 2101, 2102 of the light-transmissive side wall 210 may also have the same slope. The Fresnel lens tooth surface, combined with the transparent liquid 201 in the liquid light-concentration device, forms a liquid Fresnel lens.

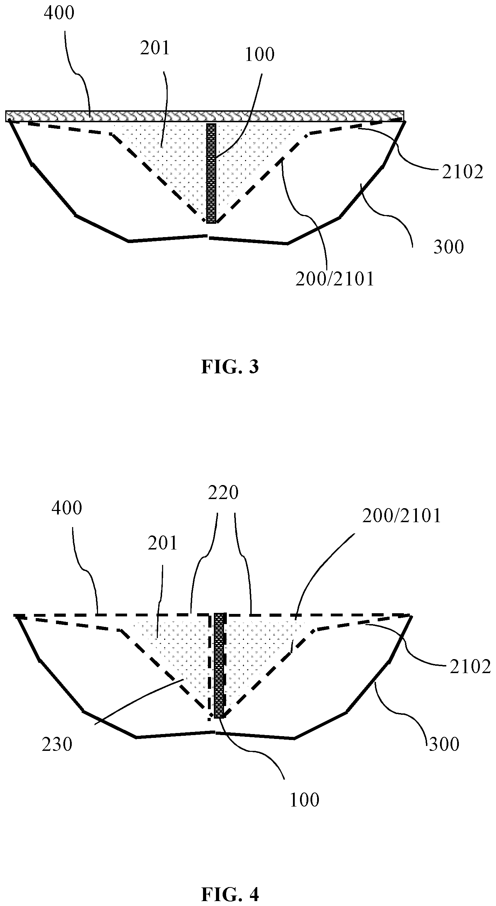

In some embodiments, as shown in FIG. 3, the light-transmissive cover 400 may be a Fresnel lens, which can be integrated with the light-transmissive top wall of the liquid light-concentration device, eliminating the need for a separate light-transmissive top wall of the liquid light-concentration device.

In some embodiments, the light-transmissive top wall or the light-transmissive cover of the liquid light-concentration device 200 can also totally reflect sunlight coming from the light-transmissive side wall 210 or the reflecting structure 300, converging part of the sunlight towards the light energy utilization device in a total reflection manner.

In some embodiments, as shown in FIG. 4, the liquid light-concentration device 200 may be composed of two enclosed accommodating chambers filled with transparent liquid, with the light energy utilization device 100 sandwiched between the two enclosed accommodating chambers. The first light energy utilization portion 110 and the second light energy utilization portion 120 are each adhered to a vertical light-transmissive wall 230 of one of the two accommodating chambers, respectively.

In some embodiments, the liquid light-concentration device 200 is designed as an inverted triangular structure (V-shape or wedge-shape). In other embodiments, the inverted polygonal light-concentrating trough is a pentagonal light-concentrating trough.

In some embodiments, the liquid light-concentration device 200 is thermally connected to the reflecting structure 300 at the bottom to utilize the reflecting structure for heat dissipation, thereby further reducing the temperatures of the various light-concentrating troughs and the light energy utilization device.

Based on the above inventive concept, the following provides further explanations through several different embodiments to better demonstrate the creativity of the present application.

### Embodiment 1:

Please refer to FIG. 1, which schematically illustrates a vertical cross-section of a solar energy utilization unit disclosed in this embodiment. In this and other embodiments, the terms "vertical" and "horizontal" are based on the orientation of placement as depicted in the figure. Due to the fact that the placement direction of the solar energy utilization unit may be adjusted according to the terrain and geographical coordinates during actual application, the orientation of placement as depicted in the figure may differ from the placement position of the solar energy utilization unit during actual application.

The solar energy utilization unit may comprise a light energy utilization device 100, a liquid light-concentration device 200, a reflecting structure 300, and a light-transmissive cover 400. The liquid light-concentration device 200 is a closed structure enclosing an accommodating chamber filled with transparent liquid 201. The liquid light-concentration device 200 may feature a light-transmissive side wall 210 and a light-transmissive top wall 220. The dashed lines in the figure indicate transparent surfaces.

The liquid light-concentration device 200 is designed as an inverted triangular structure, comprising light-transmissive side walls 210 and a horizontal light-transmissive top wall 220. The light energy utilization device 100 is vertically disposed in the middle of the inverted triangular structure and immersed in the transparent liquid 201 in the liquid light-concentration device 200. The light energy utilization device 100 is provided with a first light energy utilization portion 110 and a second light energy utilization portion 120 that are capable of receiving, converting, and utilizing sunlight. The first light energy utilization portion 110 faces to the right, while the second light energy utilization portion 120 faces to the left.

Of course, in other embodiments, the first light energy utilization portion 110 of the light energy utilization device 100 may also be separated from the transparent liquid in the liquid light-concentration device 200 by a vertical light-transmissive wall (see Embodiment 4).

Please refer to FIG. 1, the reflecting structure 300 is disposed on the outer side and bottom of the liquid light-concentration device 200, and, together with the light-transmissive side walls 210, forms the light reflecting chamber that includes a light inlet of the reflecting structure for allowing sunlight to enter the light reflecting chamber. The reflecting structure 300 reflects sunlight entering the light reflecting chamber onto the first light energy utilization portion 110 or the second light energy utilization portion 120. Specifically, a gap is left between the reflecting structure 300 and the liquid light-concentration device 200, forming the light inlet of the reflecting structure.

Please continue to refer to FIG. 1, in some more specific embodiments, the reflecting structure 300 is a trough-like structure having an internal reflective surface to reflect sunlight onto the first light energy utilization portion 110 or the second light energy utilization portion 120. FIG. 1 illustrates the convergence of three types of incident light: L1, L2, and L3. For the first type of incident light L1, it is reflected by the reflecting structure to enter the liquid light-concentration device 200 through the light-transmissive side wall 210 of the liquid light-concentration device 200, and then totally reflected by the light-transmissive top wall 220 of the liquid light-concentration device 200 onto the second light energy utilization portion 120 of the light energy utilization device 100. This fully utilizes the refraction and total reflection fulfilled by the transparent liquid 201 in the liquid light-concentration device 200 to achieve a concentrating effect. Additionally, the transparent liquid 201 may also be used to cool or absorb heat from the light energy utilization device 100, thereby improving its light energy utilization rate. In other words, the light-transmissive side wall 210 has two functions at the same time: transmitting incident light from the exterior through one surface, and then totally reflecting light from the transparent liquid 201 through another surface. For the second type of incident light L2, it enters the liquid light-concentration device 200 through its light-transmissive top wall 220 of the liquid light-concentration device 200, then is refracted by the light-transmissive side wall 210 of the liquid light-concentration device 200, then is reflected by the reflecting structure 300, and then is refracted again by the light-transmissive side wall 210 onto the second light energy utilization portion 120. For the third type of incident light L3, it enters the light reflecting chamber via the light inlet, is reflected by the reflecting structure 300, and then refracted by the light-transmissive side wall 210 of the liquid light-concentration device 200 onto the first light energy utilization portion 110.

To expand the range of the entire unit for capturing sunlight, in some embodiments, the light energy utilization device 100, the liquid light-concentration device 200 and the reflecting structure 300 may be extended in the same direction (i.e. the horizontal direction perpendicular to the paper plane on which FIG. 1 is located), forming a strip-like structure. FIG. 1 shows a vertical sectional view at a certain position along its extension direction. Of course, the unit may also be designed as a neat structure, where the vertical sectional view at any point along its extension direction is the same as shown in FIG. 1.

Please refer to FIG. 1, the light-transmissive cover 400 is connected with the reflecting structure 300 to form a closed structure for dust and snow prevention.

This embodiment can be applied to scenarios where light has a strong inclination, such as vertical or horizontal installation in high-latitude regions.

### Embodiment 2:

Please refer to FIG. 2, which illustrates a vertical sectional view of a solar energy utilization unit disclosed in this embodiment.

The solar energy utilization unit comprises a light energy utilization device 100, a liquid light-concentration device 200, a reflecting structure 300, and a light-transmissive cover 400. The liquid light-concentration device 200 and the light-transmissive cover 400 form a closed structure enclosing a sealed accommodating chamber that is filled with a transparent liquid 201. The liquid light-concentration device 200 features a light-transmissive side wall 210, eliminating the need for a light-transmissive top wall 220. The light-transmissive cover 400, together with the reflecting structure 300, also forms a closed chamber that serves to prevent dust and snow intrusion.

In this embodiment, the light-transmissive side wall 210 of the liquid light-concentration device includes a first portion 2101 and a second portion 2102. The first portion 2101 is either flat or curved, while the second portion 2102 features a Fresnel lens tooth surface. The second portion 2102, together with the transparent liquid 201 in the liquid light-concentration device 200, forms a liquid Fresnel lens.

One of the differences between this embodiment and Embodiment 1 lies in the integration of the light-transmissive top wall 220 of the liquid light-concentration device 200 with the light-transmissive cover 400; additionally, the light-transmissive side wall is provided with a second portion 2102 that is connected with the reflecting structure 300 to form a sealed light reflecting chamber. In this embodiment, sunlight is transmitted from the liquid Fresnel lens formed by the second portion 2102 and the transparent liquid 201 to the light reflecting chamber, then reflected by the reflecting structure 300 onto the first portion 2101, and ultimately directed onto the first light energy utilization portion 110 or the second light energy utilization portion 120. In this way, the transmission of sunlight from the Fresnel lens to the light reflecting chamber enhances light concentration efficiency.

In some embodiments, to expand the range of the entire unit for capturing sunlight, the light energy utilization device 100, the liquid light-concentration device 200 and the reflecting structure 300 may be extended in the same direction (i.e. the horizontal direction perpendicular to the paper plane on which FIG. 2 is located), forming a strip-like structure. FIG. 2 shows a vertical sectional view at a certain position along its extension direction. Of course, the unit may also be designed as a neat structure, where the vertical sectional view at any point along its extension direction is the same as shown in FIG. 2.

### Embodiment 3:

This embodiment presents a slight variation from Embodiment 2. In this embodiment, the light-transmissive cover 400 is a Fresnel lens, which enhances light concentration efficiency.

In some embodiments, to achieve better performance, a portion of the light-transmissive side wall 210 of the liquid light-concentration device 200 also adopts a Fresnel lens tooth surface.

### Embodiment 4:

This embodiment demonstrates another integration of the liquid light-concentration device 200 with the light-transmissive cover 400 and the light energy utilization device 100.

Please refer to FIG. 4, the difference between this embodiment and Embodiment 3 lies in that the liquid light-concentration device 200 is composed of two enclosed containers, both of which are symmetrical polygonal structures. Each container has a vertical light-transmissive wall 230 at a position where they are adjacent to each other. These vertical light-transmissive walls 230 of the two enclosed containers are in contact with the first light energy utilization portion 110 and the second light energy utilization portion 120 of the light energy utilization device 100, respectively. The light-transmissive cover 400 is replaced by the two light-transmissive top walls 220 of the liquid light-concentration device 200. In this way, the light energy utilization device 100 and the transparent liquid 201 in the liquid light-concentration device 200 are separated by a surface, thus providing better safety.

The specific examples provided above are used to illustrate the present application solely for the purpose of facilitating understanding and are not intended to limit the scope of the present application. The methods described in the various embodiments can be used in combination and are merely illustrative examples, posing no restriction on the fundamental concept of the application. For those skilled in the art, modifications to the aforementioned specific embodiments can be made based on the principles of this present application.

## Claims

1. A solar energy utilization unit, comprising:
a light energy utilization device having a first light energy utilization portion and a second light energy utilization portion that are arranged in a back-to-back configuration and are capable of receiving, converting, and utilizing sunlight.
a liquid light-concentration device having an accommodating chamber filled with a transparent liquid, the accommodating chamber having a light-transmissive top wall and an inclined light-transmissive side wall, the light energy utilization device being arranged in a middle of the accommodating chamber, the first light energy utilization portion and the second light energy utilization portion being perpendicular to the light-transmissive top wall, the light-transmissive side wall being arranged on both sides of the light energy utilization device, allowing the sunlight to be transmitted and/or totally reflected from the light-transmissive top wall or the light-transmissive side wall onto the first light energy utilization portion and the second light energy utilization portion; and
a reflecting structure forming a light reflecting chamber with the light-transmissive side wall of the liquid light-concentration device and allowing sunlight entering the light reflecting chamber to be reflected onto the light-transmissive side wall or light-transmissive top wall of the liquid light-concentration device.

2. The solar energy utilization unit according to claim 1, wherein a light inlet in communication with the light reflecting chamber is left between the reflecting structure and the liquid light-concentration device for the sunlight to enter.

3. The solar energy utilization unit according to claim 1, wherein an upper end of the light-transmissive side wall is extended onto the reflecting structure, and the light reflecting chamber is sealed, allowing the sunlight to be transmitted from the light-transmissive side wall of the liquid light-concentration device into the light reflecting chamber.

4. The solar energy utilization unit according to claim 1, wherein the light reflecting chamber is distributed on both sides and a bottom of the liquid light-concentration device.

5. The solar energy utilization unit according to claim 1, wherein the reflecting structure is a trough-like structure housing the light energy utilization device and the liquid light-concentration device, with an internal reflective surface that directs the sunlight onto the light-transmissive side wall of the liquid light-concentration device.

6. The solar energy utilization unit according to claim 1, wherein the liquid light-concentration device is an inverted triangular structure in cross section, and the light energy utilization device is vertically arranged in a middle of the inverted triangular structure.

7. The solar energy utilization unit according to claim 1, wherein the light-transmissive side wall is a plane, a folded surface, or a curved surface.

8. The solar energy utilization unit according to claim 1, wherein at least a portion of the light-transmissive side wall is a Fresnel lens tooth surface.

9. The solar energy utilization unit according to claim 8, wherein the Fresnel lens tooth surface is arranged at an upper end of the light-transmissive side wall.

10. The solar energy utilization unit according to any one of claims 1 to 9, wherein the light-transmissive top wall of the liquid light-concentration device is provided with a light-transmissive cover that, along with the reflecting structure, forms a closed chamber enclosing both the liquid light-concentration device and the light energy utilization device.

11. The solar energy utilization unit according to claim 10, wherein the light-transmissive cover is a Fresnel lens surface.

12. The solar energy utilization unit according to claim 10, wherein a transparent surface is overlapped or shared by both a top wall of the liquid light-concentration device and the light-transmissive cover.

13. The solar energy utilization unit according to any one of claims 1 to 12, wherein the liquid light-concentration device comprises two separated closed chambers, with the light energy utilization device arranged between the two closed chambers, and the first light energy utilization portion and the second light energy utilization portion are each adhered to a vertical light-transmissive wall of one of the two closed chambers, respectively.

14. The solar energy utilization unit according to any one of claims 1 to 13, wherein the transparent liquid comprises deionized pure water, glycerol, alcohol, ethylene glycol, or a mixture thereof.

15. The solar energy utilization unit according to any one of claims 1 to 14, wherein the light energy utilization device is a dual-sided photovoltaic panel or a dual-sided photothermal utilization device.
